# EUROPÄISCHE PATENTSCHRIFT

(11) **EP 3 057 387 B1**
(45) Veröffentlichungstag und Bekanntmachung des Hinweises auf die Patenterteilung: **03.07.2019**
(21) Anmeldenummer: 16151607.5
(22) Anmeldetag: 15.01.2016
(51) Int. Cl.: G01R 22/06, H05K 7/14

(54) **KOMMUNIKATIONSEINHEIT, INSBESONDERE SMARTMETER-GATEWAY**
COMMUNICATION UNIT, IN PARTICULAR SMART METER GATEWAY
UNITE DE COMMUNICATION, EN PARTICULIER PASSERELLE SMARTMETER

(30) Priorität: 23.01.2015 DE 102015201115
(43) Veröffentlichungstag der Anmeldung: 17.08.2016
(73) Patentinhaber: Power Plus Communications AG, 68167 Mannheim (DE)
(72) Erfinder: STRAUBE, Peter, 68165 Mannheim (DE)
(74) Vertreter: Patent- und Rechtsanwälte Ullrich & Naumann

(56) Entgegenhaltungen:
- EP-A1- 2 199 750
- WO-A1-2014/051619
- DE-U1-202006 006 615
- US-A1- 2001 043 062

## Beschreibung

Die Erfindung betrifft eine Kommunikationseinheit, insbesondere ein SmartMeter-Gateway, mit mehreren Leiterplatten und einem Gehäuse zur Montage auf einer Tragschiene, insbesondere auf einer Hutschiene, wobei die mehreren Leiterplatten in dem Gehäuse angeordnet sind.

Aus der Praxis bekannte Kommunikationseinheiten sind meist auf mehreren Leiterplatten (auch als Platinen oder gedruckte Schaltungen bezeichnet) aufgebaut, die in einem Gehäuse angeordnet sind. Einige Gehäuse derartiger Kommunikationseinheiten, auf die sich die vorliegende Erfindung bezieht, sind zur Tragschienenmontage ausgebildet und weisen daher eine als Aufnahme für eine Tragschiene ausgebildete Wandung - Montagewandung - auf. Die Aufnahme erstreckt sich in einer Ausdehnungsrichtung meist über die gesamte Montagewandung. In vielen Fällen ist die Aufnahme durch eine Vertiefung gebildet, in die eine Tragschiene im montierten Zustand zumindest teilweise eingreift und dort häufig mit Rastnasen oder einem anderen Befestigungsmechanismus gehalten wird. Das Gehäuse weist neben der Montagewandung weitere Wandungen auf, die den Raum innerhalb des Gehäuses begrenzen. Hierzu gehört beispielsweise die Frontwandung, die auch im montierten Zustand des Gehäuses sichtbar bleibt und daher meist Bedien- und/oder Anzeigeelemente aufweist. Die in Europa vermutlich am weitesten verbreitete Tragschiene ist als Hutschiene bekannt. Hutschienen sind nach EN 50022 genormt und werden regelmäßig in Elektroverteilern eingesetzt.

In Deutschland sind die Abmessungen der zugehörigen Gehäuse sowie deren Einbaumaße nach DIN 43880 genormt. Danach ist die Oberfläche einer Berührungsschutzabdeckung im Abstand von 52 mm von der Oberkante der Hutschiene angeordnet, die die Kontakte der einzelnen Hutschienengehäuse gegen Berührung und Manipulation schützen. Die Berührungsschutzabdeckung ist meist verplombt, wodurch ein für einen Endkunden zugänglicher Bereich (vor der Berührungsschutzabdeckung) und ein für den Endkunden unzugänglicher Bereich (hinter der Berührungsschutzabdeckung) entsteht. Das Hutschienengehäuse selbst darf die Berührungsschutzabdeckung maximal um 10 mm überragen, so dass das Hutschienengehäuse von der Oberkante der Hutschiene gemessen maximal 62 mm hoch sein darf. Im Abstand von 70 mm von der Hutschiene ist eine Türe oder eine andere Frontverkleidung angeordnet, die den gesamten Elektroverteiler mit den einzelnen Hutschienengehäusen und der Berührungsschutzabdeckung abschließt.

In der Praxis sind verschiedenste Kommunikationseinheiten in Hutschienengehäusen bekannt. Beispiele hierfür sind IP-Gateways für Türsprechanlagen (beispielsweise von der Firma Gira), IP-Gateways oder andere Interfaces für einen KNX-Bus (beispielsweise von der Firma Weinzierl Engineering GmbH) oder SmartMeter-Gateways (SM-GW). Auf letztere wird nachfolgend beispielshaft genauer eingegangen.

In Deutschland sind gewisse Ausgestaltungen eines SmartMeter-Gateways nach dem Gesetz über die Elektrizitäts- und Gasversorgung (EnWG) und dort insbesondere die §§ 21e, 21f und 21i vorgeschrieben, die in einem Schutzprofil und einer Technischen Richtlinie des Bundesamts für Sicherheit in der Informationstechnik (BSI) weiter konkretisiert sind. Technische Umsetzungen dieser Vorgaben beschreibt "FNN MS2020 - Lastenheft Konstruktion, Basiszähler und SmartMeter-Gateway" (FNN = Forum Netztechnik und Netzbetrieb im VDE (Verband der Elektrotechnik, Elektronik und Informationstechnik e.V.); MS2020 = Messsystem2020, ein Projekt des VDE). Ein SmartMeter-Gateway ist ein zentraler Baustein eines elektronischen Messsystems, das neben dem SM-GW einen oder mehrere SmartMeter (elektronische Messeinrichtungen, meist für Strom, Gas oder Wasser) umfasst. Dieser SM-GW verbindet den/die in einem LMN (Local Metrological Network) angeordneten SmartMeter mit einem HAN (Home Area Network) und den verschiedenen Marktteilnehmern (beispielsweise SM-GW-Administrator, Verteilnetzbetreiber oder Messstellenbetreiber) in einem WAN (Wide Area Network). Das FNN-Lastenheft gibt unter anderem vor, welche Schnittstellen-Anschlüsse vorgesehen sein müssen und an welcher Position des Gehäuses diese aus dem Gehäuse zu führen sind. Dazu gehören beispielsweise eine RJ45-Buchse für das HAN und Betriebsanzeigen an der Frontwandung, einen Anschluss für elektrische Versorgung am unteren Bereich des Gehäuses (mit Blick auf die Frontwandung) und Kommunikationsanschlüsse (beispielsweise für das LMN) am oberen Bereich des Gehäuses.

Die mehreren Leiterplatten innerhalb von Hutschienengehäusen sind üblicherweise parallel zur Montagewandung angeordnet. Dadurch ergibt sich - außer bei sehr schmalen und für Kommunikationseinheiten eher ungeeigneten Gehäusen - eine maximale kombinierte Fläche, d.h. auf jeder Leiterplatte steht eine maximal mögliche zusammenhängende Fläche zur Verfügung. Ferner sind die Leiterplatten dadurch rechteckig. Beides erleichtert das Routing der Leiterbahnen auf den Leiterplatten und hilft die Kosten niedrig zu halten. Entsprechend sind bei gebräuchlichen Hutschienengehäuse an oder bei der Montagewandung Befestigungsmittel vorgesehen, um eine horizontale Platte aufzunehmen. Zum elektrischen Verbinden der Leitplatten untereinander sind Stapelsteckverbinder vorgesehen.

Durch die Abmessungen der Bauteile, die jeweils auf den Leiterplatten angeordnet sind, und durch weitere Rahmenbedingungen, wie EMV (Elektro-Magnetische Verträglichkeit) oder Mindestabstände bei Netzspannung-führenden Teilen (beispielsweise in einem Netzteil), müssen die einzelnen Leiterplatten einen gewissen Abstand zueinander einhalten. Ergänzend tritt das Problem hinzu, dass viele Bauteile, wie beispielsweise RJ45-Buchsen, meist in THT (Through Hole Technology) ausgeführt sind, d.h. Lötstifte an dem Bauteil werden durch korrespondierende Löcher in der Leiterplatte gesteckt und auf der dem Bauteil gegenüberliegenden Seite der Leiterplatte mit Leiterbahnen verlötet. Dadurch wird auf beiden Seiten der Leiterplatte Fläche verbraucht. Dies führt insgesamt dazu, dass eine gewisse Packungsdichte innerhalb des Gehäuses nicht überschritten werden kann. Insbesondere bei SM-GWs, die nach dem bereits angesprochenen Lastenheft des FNN eine Breite von 4 TE (Teilungseinheit, auch Platzeinheit genannt, 1 TE entspricht 17,5 mm) und eine Höhe von 62 mm nicht überschreiten dürfen, kann dies zu Engpässen führen. Diese Engpässe werden noch gravierender, wenn zusätzliche Schnittstellen bereitgestellt werden sollen.

Aus der EP 2 199 750 A1 ist ein Zusatzgerät für eine Kommunikation mit einem Stromzähler bekannt. Das Zusatzgerät besteht aus einem Trägermodul und einem Hauptfunktionsmodul. Das Trägermodul ist zur Aufnahme auf einer Hutschiene ausgebildet und weist einen Aufnahmeschacht für das Hauptfunktionsmodul auf.

Die DE 20 2006 006 615 U1 offenbart ein Elektronikgehäuse zum Aufsetzen auf eine Tragschiene. In dem Gehäuse ist eine Basisplatine parallel zur Tragschiene angeordnet, die Kontakte zum Verbinden mit einem Tragschienenbusverbinder aufweisen kann. Zusätzlich zu der Basisplatine sind weiter Platinen innerhalb der Gehäuses angeordnet, die mit der Basisplatine direkt oder über Seitenwandungen verbunden sind. Gemäß einer Ausgestaltung sind die weiteren Platinen senkrecht zur Basisplatine und senkrecht zur Erstreckungsrichtung der Tragschiene angeordnet.

Der vorliegenden Erfindung liegt die Aufgabe zugrunde, eine Kommunikationseinheit, derart auszugestalten und weiterzubilden, dass eine effiziente Raumausnutzung des Gehäuses der Kommunikationseinheit erzielbar ist.

Erfindungsgemäß wird die voranstehende Aufgabe durch die Merkmale des Anspruchs 1 gelöst. Danach umfassen die mehreren Leiterplatten der Kommunikationseinheit eine Basis-Leiterplatte und mindestens eine Modul-Leiterplatte, die in dem Gehäuse der Kommunikationseinheit angeordnet sind, wobei eine Wandung des Gehäuses - Montagewandung - als Aufnahme für die Tragschiene ausgebildet ist, wobei die Basis-Leiterplatte bei einer Wandung des Gehäuses angeordnet ist und sich im Wesentlichen in einer Ebene parallel zu dieser Wandung erstreckt, wobei sich die mindestens eine Modul-Leiterplatte in einer Ebene orthogonal zu der Basis-Leiterplatte und orthogonal zu einer Ausdehnungsrichtung der Aufnahme für die Tragschiene erstreckt und elektrisch mit der Basis-Leiterplatte verbunden ist, wobei die Ausdehnungsrichtung der Aufnahme senkrecht zu einer Anreihwandung des Gehäuses ist und wobei jede der mehreren Modul-Leiterplatten einen vorbestimmten Funktionsbereich aufweist und als Netzteil-Modul, als Sicherheits-Modul, als Kommunikations-Modul oder als Funk-Modul ausgebildet ist.

In erfindungsgemäßer Weise ist zunächst erkannt worden, dass durch Abkehr von der gebräuchlichen Anordnung der Leiterplatten parallel zu der Montagewandung die Flexibilität und die Raumausnutzung verbessert werden kann. Stattdessen werden erfindungsgemäß Platinen - nachfolgend als Modul-Leiterplatten bezeichnet - orthogonal zu einer Ausdehnungsrichtung der Aufnahme für die Tragschiene angeordnet. Zwar wird dadurch die Berandung der Leiterplatte komplizierter, da für eine möglichst gute Flächennutzung die Leiterplatte dem Inneren des Gehäuses nachgeführt werden dürfte. Dadurch dürfte bei einem Hutschienengehäuse eine dreistufige Leiterplatte entstehen. Dies bedingt wiederum, dass das Routing der Leiterbahnen auf der Leiterplatten aufwändiger wird. Allerdings kann durch die orthogonale Anordnung deutlich flexibler auf Anforderungen hinsichtlich EMV und Mindestabständen eingegangen werden. Dieser Effekt tritt besonders deutlich bei Gehäusen zutage, die - beispielsweise bei einem Hutschienengehäuse - breiter als 3 TE (Teilungseinheiten) sind. Ferner ist die Platzierung von Buchsen, die durch eine Öffnung in einer Gehäusewandung von Außen erreichbar sind, deutlich vereinfacht.

Darüber hinaus ist es möglich, den Bereich zwischen Frontwandung und Montagewandung nahezu vollständig auszunutzen.

Zur Vermeidung von relativ teuren und sonst gebräuchlichen Stapelsteckverbinder ist zudem erfindungsgemäß eine Basis-Leiterplatte vorgesehen, die orthogonal zu der/den Modul-Leiterplatte/n angeordnet ist. Die Basis-Leiterplatte ist an einer der Wandungen des Gehäuses angeordnet und erstreckt sich in einer Ebene parallel zu dieser Wandung. Ist diese Wandung nicht vollkommen flach ausgebildet, würde sich die Basis-Leiterplatte in einer Ebene parallel zu derjenigen Fläche/denjenigen Flächen der Wandung erstrecken, die den größten Teil der Wandung ausmacht/ausmachen. Da die Basis-Leiterplatte orthogonal zu der mindestens einen Modul-Leiterplatte ist und die mindestens eine Modul-Leiterplatte orthogonal zu der Ausdehnungsrichtung der Aufnahme für die Tragschiene ist, ist die Basis-Leiterplatte parallel zu der Ausdehnungsrichtung der Aufnahme angeordnet.

Die Basis-Leiterplatte ist elektrisch mit der/den Modul-Leiterplatte/n verbunden. Dadurch ist es möglich, eine elektrische Verbindung zwischen mehreren Modul-Leiterplatten über die Basis-Leiterplatte herzustellen und auf die Verwendung von Stapelsteckverbinder zu verzichten. So kann die Basis-Leiterplatte zum Übertragen elektrischer Energie von einer Modul-Leiterplatte zu einer anderen genutzt werden oder es kann eine Kommunikationsverbindung zwischen Modul-Leiterplatten über Leiter auf der Basis-Leiterplatte hergestellt werden.

Unter dem Begriff "Ausdehnungsrichtung der Aufnahme für die Tragschiene" ist ganz allgemein zu verstehen. Wenn die Aufnahme durch eine Vertiefung in der Montagewandung des Gehäuses gebildet ist, ist die Ausdehnungsrichtung die Längsrichtung der Vertiefung. Wenn die Aufnahme durch Stege, Stifte oder ähnlich geartete Erhebungen gebildet ist, durch die ein Halten des Gehäuses in der Tragschiene erreichbar ist, wird unter Ausdehnungsrichtung die Längsrichtung der Tragschiene verstanden, wenn die Tragschiene in der Aufnahme angeordnet ist.

Prinzipiell kann die Basis-Leiterplatte bei einer relativ beliebigen Wandung des Gehäuses angeordnet sein, solange gewährleistet ist, dass die Wandung im Wesentlichen parallel zu der Ausdehnungsrichtung der Aufnahme angeordnet ist. Geht man davon aus, dass die Frontwandung parallel zu der Montagewandung angeordnet ist (wie beispielsweise bei einem Hutschienengehäuse), so kann die Basis-Leiterplatte bei einer der Wandungen des Gehäuses angeordnet sein, die parallel zu der Ausdehnungsrichtung der Aufnahme und senkrecht zu der Montagewandung bzw. senkrecht zu der Frontwandung angeordnet ist. In einer bevorzugten Ausgestaltung ist die Wandung, bei der die Basis-Leiterplatte angeordnet ist, jedoch die Montagewandung. Da die Montagewandung üblicherweise nicht zugänglich ist und das Anbringen von Anschlüssen durch die Montagewandung daher wenig sinnvoll ist, wird durch diese Anordnung der Basis-Leiterplatte die Platzierung eines Anschlusses nicht beeinflusst. Dadurch wird die Flexibilität weiter verbessert. Ferner bietet eine Anordnung der Basis-Leiterplatte bei der Montagewandung eine relativ große Fläche für die Nutzung der Basis-Leiterplatte. So kann beispielsweise bei einem Hutschienengehäuse eine sehr große Leiterplatte mit Platz für viele Leiterbahnen zum Verbinden von mehreren Modul-Leiterplatten realisiert werden.

Es sei darauf hingewiesen, dass die Basis-Leiterplatte prinzipiell auch zweigeteilt sein kann. Eine Zweiteilung bietet insbesondere bei Anordnung der Basis-Leiterplatte bei der Montagewandung ergänzende Vorteile. Im Inneren eines Hutschienengehäuses ist in der Montagewandung durch die Aufnahme für die Hutschiene eine Erhöhung gebildet, die eine Platzierung der Basis-Leiterplatte limitiert. Beidseits dieser Erhöhung ist das Hutschienengehäuse tiefer. Die Basis-Leiterplatte kann zweigeteilt sein und diesen Umstand nutzen: Ein erster Teil der Basis-Leiterplatte wäre dann auf der einen Seite der Vertiefung und ein zweiter Teil der Basis-Leiterplatte auf der anderen Seite der Vertiefung angeordnet. Dadurch können die Leiterplatten tiefer platziert werden. Diese Aufteilung kann sich auch in der Nutzung der beiden Teile wiederspiegeln. So können beispielsweise auf der einen Seite Energieversorgungsleitungen, auf der anderen Seite Kommunikationsleitungen angeordnet sein. Entsprechendes gilt auch für andere Tragschienengehäuse.

Zum Anschluss von Endgeräten und/oder weiteren Kommunikationsgeräten oder auch einer externen Antenne kann die Kommunikationseinheit ein oder mehrere Schnittstellen-Anschlüsse aufweisen, die vorzugsweise als Buchsen ausgebildet sind. Beispielhaft sei auf eine RJ45-Buchse, eine RS485-Buchse, eine FAKRA (Fachkreis Automobil)-Buchse oder Klemmen zur Energieversorgung der Kommunikationseinheit hingewiesen. Ein derartiger Schnittstellen-Anschluss ist vorzugsweise durch eine Öffnung in einer der Wandungen des Tragschienengehäuses erreichbar bzw. durch diese Öffnung geführt. Je nach Art des Schnittstellen-Anschlusses kann der Schnittstellen-Anschluss dabei im Wesentlichen bündig mit der Oberfläche des Gehäuses abschließen. Dies bietet sich beispielsweise bei einer RJ45-Buchse an, die an einer seitlichen Wandung des Gehäuses angeordnet ist. Durch Anordnung eines Schnittstellen-Anschlusses auf einer Modul-Leiterplatte ist eine hohe Flexibilität bei der Platzierung des Anschlusses erreichbar. Bis auf den Bereich, im dem die Basis-Leiterplatte angeordnet ist, stehen alle Seiten einer Modul-Leiterplatte für das Platzieren des Anschlusses zur Verfügung. Wenn die Basis-Leiterplatte bei der Montagewandung angeordnet ist, sind damit alle anderen Seiten der Platine für Schnittstellen-Anschlüsse nutzbar. Dadurch kann an praktisch jeder Höhe des Gehäuses an Schnittstellen-Anschluss angeordnet sein. Für die Platzierung in Richtungen parallel zu der Ausdehnungsrichtung der Aufnahme kann die Modul-Leiterplatte relativ zu der Basis-Leiterplatte verschoben werden.

Entsprechende Ausführungen gelten für das Anbringen von Anzeigeelemente, die beispielsweise an der Frontwandung angeordnet sind. Auch hier kann durch die Verwendung von orthogonal angeordneten Modul-Leiterplatten eine größere Flexibilität erreicht werden.

Die Basis-Leiterplatte ist vorzugsweise derart ausgestaltet, dass sie sich auf die gesamte Breite des Gehäuses, also in einer Richtung parallel zu der Ausdehnungsrichtung der Aufnahme, erstreckt. Dadurch sind durch die Basis-Leiterplatte keine Limitierungen hinsichtlich der Platzierungen der Modul-Leiterplatten relativ zu der Basis-Leiterplatte gegeben. Ferner erhöht sich die Stabilität, da sich die Basis-Leiterplatte an den beiden gegenüberliegenden Wandungen des Gehäuses abstützen kann. In einer Richtung senkrecht zu der Ausdehnungsrichtung der Aufnahme ist die Basis-Leiterplatte vorzugsweise ebenso bis zu den beiden angrenzenden Wandungen des Gehäuses ausgedehnt. Damit steht eine maximale Fläche für elektrische Leiter zur Verfügung und die mechanische Stabilität wird begünstigt. Es ist jedoch auch - wie bereits ausgeführt - möglich, dass die Basis-Leiterplatte in zwei oder mehr Teile untergliedert ist, wobei die Teile der Basis-Leiterplatte dann vorzugsweise jeweils in einer Richtung senkrecht zu der Ausdehnungsrichtung der Ausnehmung den zur Verfügung stehenden Raum nahezu vollständig ausfüllen.

Hinsichtlich der Dimensionierung der Modul-Leiterplatten besteht ebenso relativ große Freiheit. So kann beispielsweise eine der Modul-Leiterplatten relativ klein ausgebildet sein, d.h. die Modul-Leiterplatte erstreckt sich nicht in maximal möglicher Weise nahe an die Wandungen des Gehäuses. Dies kann sich beispielsweise anbieten, wenn ein Bauteil auf einer benachbarten Modul-Leiterplatte die Leiterplatten-Ebene schneidet und damit nicht die gesamte Fläche nutzbar wäre. Hier kann eine kleinere Modul-Leiterplatte eine Nutzung des Platzes verbessern. Bevorzugter Weise erstreckt sich die Modul-Leiterplatte aber im Wesentlichen bis nahe zu den Wandungen des Gehäuses. Bei einem gestuften Gehäuse, wie dies beispielsweise bei einem Hutschienengehäuse vorliegt, würde sich die Modul-Leiterplatte damit von nahe der Montagewandung bis nahe an die Frontwandung und von der oberen Seitenwandung zur unteren Seitenwandung erstrecken.

Sowohl bei der Basis-Leiterplatte als auch bei der Modul-Leiterplatte bedeutet "nahe" einer Wandung, dass zumindest ausreichend Platz vorhanden ist, um Fertigungstoleranzen auszugleichen. Ferner sollte ein Einbringen der Leiterplatten in das Gehäuse durch eine zu enge Dimensionierung nicht beeinträchtigt werden.

Gleichzeitig kann "nahe" aber auch noch umfassen, dass mehrere Millimeter, beispielsweise 5 mm Platz zwischen Leiterplatte und angrenzender Wandung vorhanden ist.

Die mindestens eine Modul-Leiterplatte kann durch eine Steckverbindung reversibel mit der Basis-Leiterplatte verbunden sein. Dazu kann auf der Basis-Leiterplatte eine Buchse und auf der Modul-Leiterplatte ein entsprechender, um 90° abgewinkelter Stecker vorgesehen sein. Umgekehrt kann auch auf der Basis-Leiterplatte ein Stecker und auf der Modul-Leiterplatte eine entsprechende, um 90° abgewinkelte Buche angeordnet sein. Der Stecker kann dabei in einer besonders einfachen Ausgestaltung auf einer oder mehreren Reihen von Stiften bestehen, die in zugehörige Löcher in der Buchse eingesteckt werden. Im Gegensatz zu den sonst gebräuchlichen Stapelsteckverbinder sind derartige Steckverbindungen relativ günstig. Auf diese Weise kann ein flexibler Austausch von Modul-Leiterplatten ohne aufwändige Maßnahmen erreicht werden.

Alternativ kann die Verbindung zwischen Basis-Leiterplatte und Modul-Leiterplatte durch Lötstifte oder einen Lötkamm erfolgen. Bei einer Verbindung über Lötstifte würde mehrere Stiften, die in einer oder mehreren Reihen angeordnet sind und vorzugsweise über einen Kunststoffsteg miteinander verbunden und um 90° abgewinkelt sind, in Löcher in der Modul-Leiterplatte eingesteckt und verlötet. Die Lötstifte können dann mit ihren anderen Enden in Löcher auf der Basis-Leiterplatte eingesteckt und dort verlötet werden. Die Reihenfolge der beiden Montageschritte kann auch umgekehrt sein. Es ist auch denkbar, dass die Lötstifte in mehreren Gruppen angeordnet sind. Dabei kann beispielsweise eine Gruppe für Energieversorgungsleitungen und eine Gruppe für eine Kommunikation verwendet werden. Gleichzeitig kann durch eine Gruppierung auf Gegebenheiten innerhalb des Gehäuses eingegangen werden. So kann beispielsweise bei einer Anordnung der Basis-Leiterplatte bei der Montage-Wandung in einem Hutschienengehäuse der Bereich, der sich über der Aufnahme für die Hutschiene befindet, für Lötstifte ausgespart werden. Auf diese Weise könnte die Basis-Leiterplatte direkt auf dem Gehäuse aufliegen. Die Lötstifte können in unregelmäßigen Abständen zueinander angeordnet sein. Vorzugsweise sind diese jedoch äquidistant zueinander angeordnet. Bei bilden von Gruppen von Lötstiften wären die Lötstifte innerhalb einer Gruppe äquidistant ausgebildet. Die Löcher können jeweils mit Leiterbahnen auf der Basis-Leiterplatte bzw. auf der Modul-Leiterplatte verbunden sein und gegebenenfalls durchkontaktiert sein, d.h. die Innenseite der Löcher ist leitfähig, beispielsweise durch eine Beschichtung oder eine Hülse, und kann auf beiden Seiten der Leiterplatte mit Leitern verbunden sein.

Bei einer Verbindung über einen Lötkamm weist die Modul-Leiterplatte an dem der Basis-Leiterplatte zugewandten Rand mehrere Aussparungen auf, die derart entlang des Randbereichs angeordnet sind, dass durch die zwischen den Aussparungen entstehenden Stege eine kammartige Struktur - einen Lötkamm - bilden. Die Stege werden in Durchgänge eingesteckt, die in der Basis-Leiterplatte ausgebildet sind. Auf den Stegen können auf einer oder beiden Seiten der zugehörigen Modul-Leiterplatte Leiterbahnen angeordnet sein. Entsprechend wären an den Durchgängen Leiterbahnen der Basis-Leiterplatte angeordnet. Dabei kann eine Durchkontaktierung erfolgen, d.h. die in den Durchgängen ist ein leitfähiger Bereich, beispielsweise über eine Beschichtung oder eine Hülse, angeordnet, der mit Leiterbahnen auf beiden Seiten der Basis-Leiterplatte verbunden ist. Nach Einstecken des Lötkamms in die Durchgänge würden die Leiterbahnen auf den Stegen mit den Leiterbahnen bei und gegebenenfalls in den Durchgängen verlötet. Durch Verwendung eines Lötkamms kann eine einfache, stabile und relativ kostengünstige Verbindung zwischen einer Modul-Leiterplatte und der Basis-Leiterplatte hergestellt werden.

Sowohl bei einer reversiblen Verbindung über ein Steckverbinder als auch bei einer Verbindung, die nur mit besonderem Werkzeug (beispielsweise einem Lötkolben) gelöst werden kann, kann die Verbindung derart ausgestaltet sein, dass eine Modul-Leiterplatte mechanisch ausreichend stabil auf der Basis-Leiterplatte gehalten wird. Dadurch kann auf zusätzliche mechanische Stabilisierungsmaßnahmen, beispielsweise über Befestigungswinkel, verzichtet werden.

Die Basis-Leiterplatte kann durch Führungsschienen gehalten sein, die an Innenwandungen des Gehäuses ausgebildet sind. Alternativ oder zusätzlich kann die mindestens eine Modul-Leiterplatte durch an den Innenwandungen des Gehäuses ausgebildeten Führungsschienen gehalten sein. Dabei bietet es sich an, wenn die Führungsschienen an zwei gegenüberliegenden Wandungen ausgebildet sind, und zwar derart, dass die Basis-Leiterplatte und/oder die jeweilige Modul-Leiterplatte in gegenüberliegende Führungsschienen einschiebbar sind. So könnten beispielsweise bei einem Hutschienengehäuse an den beiden Anreihwandungen (Wandung senkrecht zu der Ausdehnungsrichtung der Aufnahmen) nahe bei der Montagewandung Führungsschienen ausgebildet sein, in die die Basis-Leiterplatte eingeschoben werden können.

Alternativ oder zusätzlich zu der Verwendung von Führungsschienen ist es denkbar, dass die Basis-Leiterplatte über Abstandhalter, Distanzhülsen oder Distanzbolzen an einer der Innenwandungen des Gehäuses fixiert ist. Diese Fixierungsmittel können aus Metall oder Kunststoff gefertigt sein. Die Leiterplatte kann in den Fixierungsmitteln mit Schrauben oder Muttern befestigt werden, die in das jeweilige Fixierungsmittel eingeschraubt werden. Die Fixierungsmittel können auch durch an einer der Innenwandung angeordnete Spreizmuttern gebildet sein, in die die Leiterplatte eingesteckt wird.

Bei Vorsehen mehrerer Modul-Leiterplatten können die mehreren Modul-Leiterplatten parallel zueinander ausgerichtet sein. Vorzugsweise können diese jeweils elektrisch und/oder mechanisch mit der Basis-Leiterplatte verbunden sein.

Prinzipiell können die Leiterplatten der erfindungsgemäßen Kommunikationseinheit verschiedenste Funktionen erfüllen. Während die Basis-Leiterplatte bei Vorsehen mehrere Modul-Leiterplatten vorwiegend der Verbindung der Modul-Leiterplatten untereinander dienen dürfte, würden die Modul-Leiterplatten selbst Funktionen oder Teilfunktionen der Kommunikationseinheit übernehmen. Dabei können die Funktionen bzw. Teilfunktionen prinzipiell relativ beliebig über die Modul-Leiterplatten verteilt sein. So können beispielsweise zwei Modul-Leiterplatten gemeinsam eine Kommunikation zwischen HAN und WAN bereitstellen. In einer bevorzugten Ausgestaltung übernehmen die Modul-Leiterplatten jedoch jeweils vorbestimmte Funktionsbereiche, die sie vorzugsweise ohne eine weitere Modul-Leiterplatte erfüllen können. Dadurch entsteht eine echte Modularität, die sich begünstigend auf die Flexibilität und die Kosten auswirkt. Beispiele bevorzugter Funktionsbereiche sind ein Netzteil-Modul, eine Sicherheits-Modul, eine Kommunikations-Modul (beispielsweise ein PLC (PowerLine Communication)-Modems) oder ein Funk-Modul (beispielsweise zur Bereitstellung eines funkbasierten LMN).

Ein Netzteil-Modul würde den Funktionsbereich "Energieversorgung der Kommunikationseinheit" übernehmen. Dabei würde das Netzteil-Modul mit einer elektrischen Energiequelle verbunden, die vorzugsweise durch ein Energieversorgungsnetz (beispielsweise ein einphasiges Netz mit Wechselspannung bei 230 V) gebildet ist. Die durch das Netzteil-Modul erzeugte Gleichspannung würde über Leiter auf der Basis-Leiterplatte an die weiteren Modul-Leiterplatten geleitet. Die Netzspannung kann entweder direkt oder über die Basis-Leiterplatte in der Netzteil-Modul eingegeben werden. Bei einer Eingabe über die Basis-Leiterplatte könnten auf der Basis-Leiterplatte Anschlussmittel, beispielsweise Schraubklemmen, vorgesehen sein, die eine Verbindung zu der Energiequelle herstellen. Leiter auf der Basis-Leiterplatte würden eine Verbindung zwischen diesen Anschlussmitteln und dem Netzteil-Modul herstellen. Diese Anordnung kann sich anbieten, wenn die Anschlussmittel an einer besonderen Stelle oder in einer besonderen Ausrichtung angeordnet werden soll, die möglicherweise nicht ideal über Anschlussmittel an dem Netzteil-Modul erreichbar ist. Bei einer direkten Eingabe wären diese Anschlussmittel direkt auf dem Netzteil-Modul vorgesehen. Diese Ausgestaltung bietet den Vorteil, dass bei Verwenden einer Netzspannung nur das Netzteil-Modul für die Netzspannung ausgelegt sein und keine Netzspannung über die Basis-Leiterplatte geleitet werden muss.

Ein Sicherheits-Modul könnte den Funktionsbereich "Sicherung der Kommunikation" übernehmen. Damit wäre das Sicherheits-Modul für das Signieren und/oder Verschlüsseln von zu versendenden Daten zuständig. Bei einem SmartMeter-Gateway kann dieses Sicherheit-Modul beispielsweise die Funktionen des Sicherheitsmoduls nach dem Schutzprofil des BSI übernehmen.

Ein Kommunikations-Modul kann den Funktionsbereich "Bereitstellen eines WAN-Interfaces" übernehmen. In einer einfachen Ausgestaltung kann das Kommunikations-Modul eine Ethernet-Schnittstelle bereitstellen, die eine Kommunikation zwischen einem (externen) Ethernet-Gerät und einer der anderen Modul-Leiterplatten über Leiter auf der Basis-Leiterplatte ermöglicht. In einer anderen möglichen Ausgestaltung kann das Kommunikations-Modul ein Modem für BPL (Breitband-PowerLine) implementieren.

Ein Funk-Modul kann den Funktionsbereich "Funkkommunikation" übernehmen. Wenn die Kommunikationseinheit ein SmartMeter-Gateway ist, kann das Funk-Modul beispielsweise einen drahtlosen Zugang zum LMN und damit eine Schnittstelle zu einem Wireless M-Bus bereitstellen. Es wäre auch denkbar, dass ein Funk-Modul eine W-LAN (Wireless Local Area Network)-Zugang bereitstellt, über die beispielsweise ein Endkunde - im Beispiel des SM-GW - einen Zugang zu dem HAN erhält.

Vorzugsweise stellt die Kommunikationseinheit eine Verbindung zwischen mindestens zwei Netzwerken her. Diese mindestens zwei Netzwerke können prinzipiell relativ beliebig gebildet sein. In der bevorzugten Ausgestaltung der Kommunikationseinheit sind die Netzwerke durch ein LMN, ein HAN und ein WAN gebildet. Als Implementierung der Netzwerke wird vorzugsweise Ethernet, PLC bzw. BPL oder Funk eingesetzt.

Es gibt nun verschiedene Möglichkeiten, die Lehre der vorliegenden Erfindung in vorteilhafter Weise auszugestalten und weiterzubilden. Dazu ist einerseits auf die dem Anspruch 1 bzw. 12 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine typische Einbausituation einer Kommunikationseinheit in einem Hutschienengehäuse,
- Fig. 2: eine Schrägansicht der Kommunikationseinheit gemäß Fig. 1,
- Fig. 3: eine Schrägansicht eines geöffneten Gehäuses mit einer aus der Praxis bekannte Anordnung zweier Leiterplatten,
- Fig. 4: eine Schrägansicht eines geöffneten Gehäuses mit einer erfindungsgemäßen Anordnung von Leiterplatten und
- Fig. 5: verschiedene Ansichten einer erfindungsgemäßen Anordnung von vier Modul-Leiterplatten auf einer Basis-Leiterplatte.

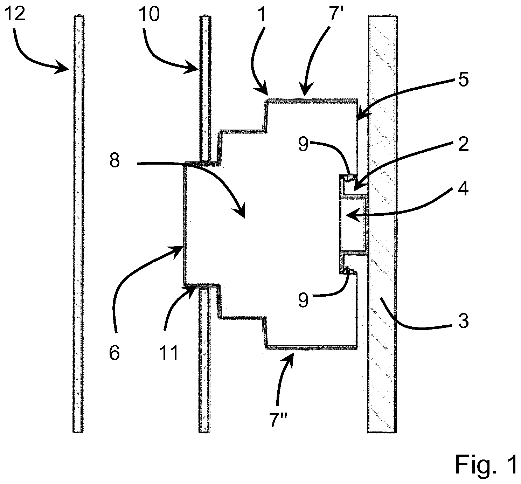

Fig. 1 zeigt eine typische Einbausituation einer erfindungsgemäßen Kommunikationseinheit in einem Gehäuse 1 zur Montage auf einer Hutschiene. Das Gehäuse 1 ist auf einer Hutschiene montiert, die als Tragschiene 2 im Sinne der vorliegenden Erfindung fungiert und die an einer Wand 3 angebracht ist. Hierzu weist das Gehäuse 1 eine als Aufnahme 4 für die Tragschiene 2 ausgebildete Wandung - Montagewandung 5 auf. Die Aufnahme 4 ist als Vertiefung in der Montagewandung 5 ausgebildet und erstreckt sich über die gesamte Montagewandung 5. Die Aufnahme ist dabei gerade ausgebildet und definiert eine Ausdehnungsrichtung, die in Fig. 1 senkrecht zur Zeichenebene ist. Die der Montagewandung 5 gegenüberliegende Wandung des Gehäuses wird nachfolgend als Frontwandung 6 bezeichnet. Des Weiteren weist das Gehäuse 1 zwei parallel zur Ausdehnungsrichtung der Aufnahme 4 und senkrecht zur Montagewandung ausgerichtete Wandungen - untere Seitenwandung 7' und obere Seitenwandung 7" - und zwei orthogonal zur Ausdehnungsrichtung der Aufnahme 4 verlaufende Wandungen - Anreihwandung 8 - auf. Der oberen und unteren Seitenwandung 7' und 7" schließen sich weitere Wandungen des Gehäuses an, die gemeinsam das Gehäuse in Richtung Frontwandung in zwei Stufen verjüngen.

Zur Fixierung des Gehäuses 1 auf der Tragschiene 2 sind in der Aufnahme 4 Arretierungsnasen 9 vorgesehen. Eine der Arretierungsnasen 9 ist dabei federnd oder federnd gelagert, so dass eine Entnehmbarkeit des Gehäuses 1 von der Tragschiene 2 gegeben ist. Es ist zu erkennen, dass sich durch die Aufnahme 4 im Inneren des Gehäuses eine Erhebung bilden wird. Dadurch ist beidseits der Aufnahme 4 das Gehäuse tiefer als bei der Erhebung (bzw. der Aufnahme) selbst.

Parallel zu der Wand 3 ist eine Berührungsschutzabdeckung 10 angeordnet, die den Bereich zwischen Berührungsschutzabdeckung 10 und Wand 3 gegenüber dem der Tragschiene 2 abgewandten Bereich abschirmt. Auf diese Weise wird eine Berührung und Manipulation im Bereich zwischen Berührungsschutzabdeckung 10 und Wand 3 verhindert. Die Berührungsschutzabdeckung 10 weist mindestens eine Öffnung 11 auf, durch die ein Teil des Gehäuses 1 durchgeführt werden kann und durch die die Frontwandung 6 auch bei angebrachter Berührungsschutzabdeckung 5 sichtbar bleibt. Die Frontwandung 6 kann bündig mit der Berührungsschutzabdeckung 5 abschließen. In dem in Fig. 1 dargestellten Fall ragt das Gehäuse einige Millimeter über die Berührungsschutzabdeckung 5 hinaus, so dass auch ein Teil der letzten Stufe des Gehäuses, der parallel zur Seitenwandung 7' bzw. 7" angeordnet ist, sichtbar wird. Gemäß DIN 43880 darf das Gehäuse 1 um maximal 10 mm über die Berührungsschutzabdeckung 5 hinausragen.

Die gesamte Anordnung ist durch eine Türe 12 abgeschlossen, die einen weiteren Schutz der dahinter liegenden Elemente bietet. Die in Fig. 1 dargestellte Einbausituation für das Gehäuse 1 der Kommunikationseinheit ist bei hutschienenbasierten Elektroverteilern weit verbreitet.

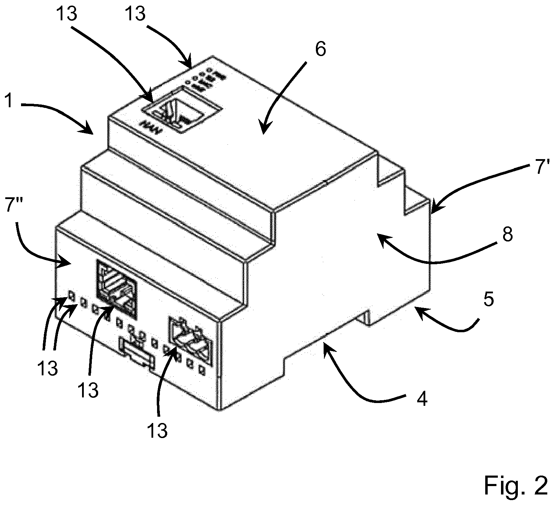

In Fig. 2 ist eine Schrägansicht des Gehäuses 1 dargestellt. Das Gehäuse ist 4 TE (Teilungseinheiten) breit. Die Frontwandung 6 weist Durchbrüche 13 auf, durch die Elemente der Kommunikationseinheit sichtbar bzw. zugänglich sind. Durch einen dieser Durchbrüche 13 ist ein Schnittstellen-Anschluss zugänglich, der in Form einer RJ45-Buchse ausgestaltet ist. Bei Ausgestaltung der Kommunikationseinheit als SmartMeter-Gateway ist über diese RJ45-Buchse ein Zugang zu dem HAN bereitgestellt. Durch weitere Durchbrüche 13 in der Frontwandung 6 sind Betriebsanzeigen sichtbar, die durch LEDs gebildet sind und Informationen über den Status der Kommunikationseinheit darstellen können. An der unteren Seitenwandung 7" sind weitere Durchbrüche 13 gezeigt. Durch den linken rechteckigen Durchbruch 13 ist eine weitere RJ45-Buchse sichtbar, die einen weiteren Schnittstellenanschluss bereitstellt. Der rechte im Wesentlichen rechteckige Durchbruch 13 gibt eine Buchse zum Anschluss einer Energiequelle frei. Eine Reihe von mehreren Durchbrüchen 13 in der Seitenwandung 7" nahe der Montagewandung 5 ermöglicht einen Luftaustausch zur Belüftung des Gehäuses.

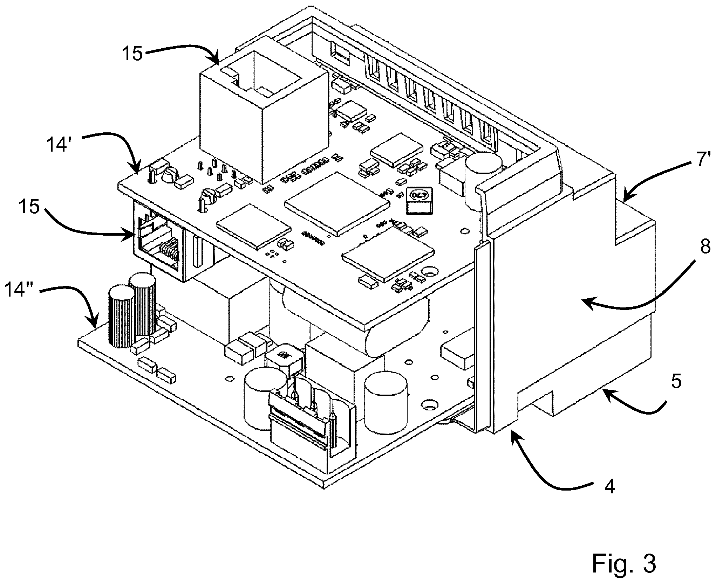

In Fig. 3 ist eine aus der Praxis bekannte Anordnung von zwei Leiterplatten 14' und 14" in einem Gehäuse parallel zur Frontwandung bzw. parallel zur Montagewandung gezeigt. Die untere der beiden Leiterplatten 14' ist bei der Montagewandung 5 angeordnet, obere der beiden Leiterplatten 14" ist nahe der Frontwandung platziert, wobei hier die die Frontwandung bildende Abdeckung nicht eingezeichnet ist. Auf der oberen Leiterplatte 14' sind Schnittstellen-Anschlüsse 15 in Form von RJ45-Buchsen angeordnet.

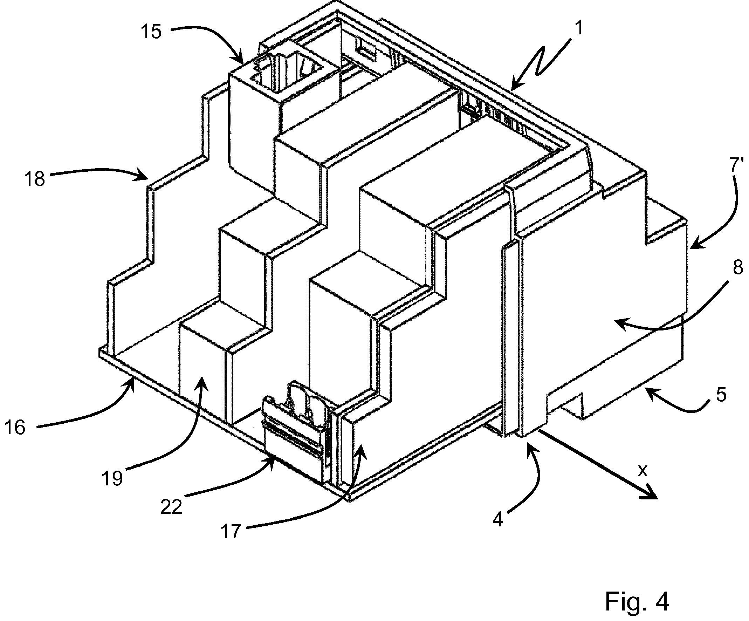

Fig. 4 zeigt in einer Schrägansicht einer erfindungsgemäßen Kommunikationseinheit, wobei nur ein Teil des Gehäuses 1 dargestellt ist. In dem Gehäuse 1 ist bei der Montagewandung 5 eine Basis-Leiterplatte 16 angeordnet. Die Basis-Leiterplatte 16 erstreckt sich dabei weitgehend von der oberen Seitenwandung 7' zu der unteren Seitenwandung 7" und von der einen Anreihwandung zu der anderen. Senkrecht zu der Basis-Leiterplatte und senkrecht zu der Ausdehnungsrichtung x der Aufnahme 4 sind drei Modul-Leiterplatten 17, 18 und 19 angeordnet. Die Berandung der Modul-Leiterplatten 17, 18, 19 ist dabei der Form des Gehäuses nachgeführt, so dass auch entsprechend die Modul-Leiterplatten 17, 18, 19 eine dreistufige Form haben, die sich von der Montageseite 5 zur Frontseite 6 stufenweise verjüngt. Jede der Modul-Leiterplatten dient einer vordefinierten Funktion. In dem in Fig. 4 dargestellten Ausführungsbeispiel ist die ganz rechts dargestellte Modul-Leiterplatte als Netzteil-Modul 17 ausgebildet. Eine Anschlussbuchse 22 zum Anschluss an eine Netzspannung ist dabei auf der Basis-Leiterplatte 16 angeordnet. Die Netzspannung wird von der Anschlussbuchse über nicht dargestellte Leiter auf der Basis-Leiterplatte in das Netzteil-Modul 17 geleitet. Da in dem Netzteil-Modul 17 relativ hohe Spannungen anliegen, ist das Netzteil-Modul 17 in einem Gehäuse innerhalb des Gehäuses 1 gekapselt. Die in Fig. 4 links eingezeichnete Modul-Leiterplatte ist eine Kommunikationsleiterplatte, die einer Kommunikation mit externen Geräten, also mit Geräten außerhalb der Kommunikationseinheit, dient. Beispielhaft für diese Kommunikationsfähigkeit ist ein Schnittstellenanschluss 15 in Form einer RJ45-Buchse eingezeichnet. Die mittlere Modul-Leiterplatte 19 ist ein Sicherheits-Modul 19, das einer gesicherten Kommunikation über die oder zumindest einzelne der Schnittstellen der Kommunikationseinheit dient. Zur Sicherung gegenüber Manipulation ist das Sicherheits-Modul 19 ebenso in einem Gehäuse innerhalb des Gehäuses 1 gekapselt.

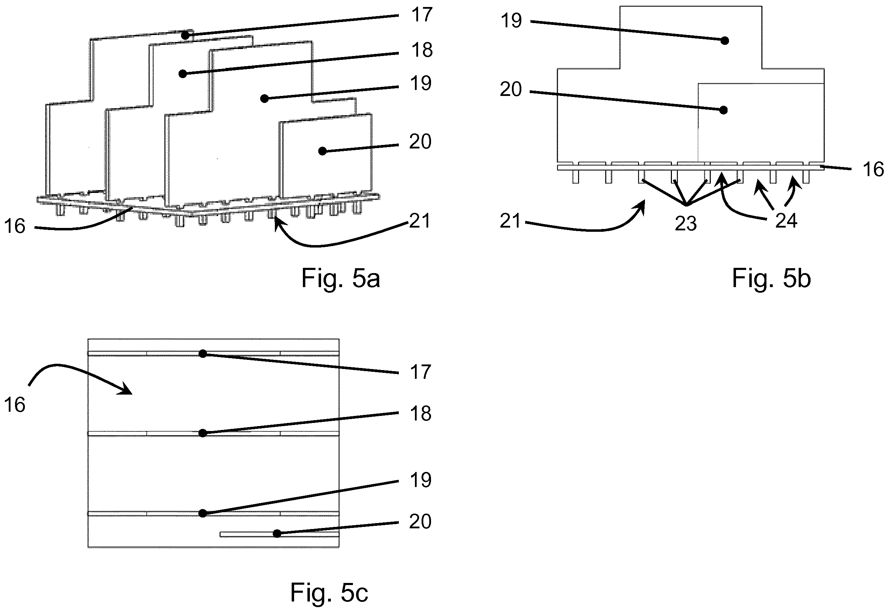

Die einzelnen Teilfiguren von Fig. 5 zeigen verschiedene Ansichten einer erfindungsgemäßen Anordnung von Leiterplatten. Fig. 5a zeigt eine Schrägansicht einer erfindungsgemäßen Anordnung von Modul-Leiterplatten 17, 18, 19, 20 auf der Basis-Leiterplatte 16. In Fig. 5b ist eine Seitenansicht der erfindungsgemäßen Anordnung aus Fig. 5a und Fig. 5c eine Draufsicht der erfindungsgemäßen Anordnung aus Fig. 5a dargestellt. Die der Basis-Leiterplatte 16 zugewandte Seite der Modul-Leiterplatten 17, 18, 19, 20 weist jeweils einen Lötkamm 21 auf, der durch eine Vielzahl von äquidistanten Stegen 23 zwischen entsprechenden Aussparungen 24 gebildet ist. Der Lötkamm 21 jeder Modul-Leiterplatte 17, 18, 19, 20 ist nahezu vollständig in korrespondierende Durchgänge in der Basis-Leiterplatte 16 eingesteckt und verlötet. Dadurch sind die Modul-Leiterplatten 17, 18, 19, 20 mit der Basis-Leiterplatte 16 sowohl elektrisch als auch mechanisch verbunden. Im Konkreten sind in Fig. 5 dargestellten Modul-Leiterplatten in Form eines Netzteil-Moduls 17, eines Kommunikations-Moduls 18, eines Sicherheits-Moduls 19 und eines Funk-Moduls 20 gezeigt. Funk-Modul 20 ist dabei auf einer relativ kleinen Modul-Platine ausgebildet.

Hinsichtlich weiterer vorteilhafter Ausgestaltungen der erfindungsgemäßen Kommunikationseinheit wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele der erfindungsgemäßen Kommunikationseinheit lediglich zur Erörterung der beanspruchten Lehre dienen, diese jedoch nicht auf die Ausführungsbeispiele einschränken.

### Bezugszeichenliste

- 1: Gehäuse
- 2: Tragschiene
- 3: Wand
- 4: Aufnahme (für Tragschiene)
- 5: Montagewandung
- 6: Front-Wandung
- 7: Seitenwandung
- 8: Anreihwandung
- 9: Arretierungsnasen
- 10: Berührungsschutzabdeckung
- 11: Öffnung (in Berührungsschutzabdeckung)
- 12: Tür
- 13: Durchbruch
- 14: Leiterplatten
- 15: Schnittstellen-Anschluss
- 16: Basis-Leiterplatte
- 17: Netzteil-Modul
- 18: Kommunikations-Modul
- 19: Sicherheits-Modul
- 20: Funk-Modul
- 21: Lötkamm
- 22: Anschlussbuchse für Netzspannung
- 23: Stege
- 24: Ausnehmungen

## Patentansprüche

1. Kommunikationseinheit, insbesondere SmartMeter-Gateway, mit einer Basis-Leiterplatte (16), mindestens einer Modul-Leiterplatte (17, 18, 19, 20) und einem Gehäuse (1) zur Montage auf einer Tragschiene (2), insbesondere auf einer Hutschiene, wobei eine Wandung des Gehäuses - Montagewandung (5) - als Aufnahme (4) für die Tragschiene ausgebildet ist,
wobei die Basis-Leiterplatte (16) und die mindestens eine Modul-Leiterplatte (17, 18, 19, 20) in dem Gehäuse (1) angeordnet sind,
wobei die Basis-Leiterplatte (16) bei einer Wandung (5, 6, 7) des Gehäuses (1) angeordnet ist und sich im Wesentlichen in einer Ebene parallel zu dieser Wandung erstreckt,
wobei sich die mindestens eine Modul-Leiterplatte (17, 18, 19, 20) in einer Ebene orthogonal zu der Basis-Leiterplatte (16) und orthogonal zu einer Ausdehnungsrichtung (x) der Aufnahme (4) für die Tragschiene (2) erstreckt und elektrisch mit der Basis-Leiterplatte (16) verbunden ist, wobei die Ausdehnungsrichtung (x) der Aufnahme (4) senkrecht zu einer Anreihwandung (8) des Gehäuses (1) ist und
wobei jede der mehreren Modul-Leiterplatten (17, 18, 19, 20) einen vorbestimmten Funktionsbereich aufweist und als Netzteil-Modul (17), als Sicherheits-Modul (18), als Kommunikations-Modul (19) oder als Funk-Modul (20) ausgebildet ist.

2. Kommunikationseinheit nach Anspruch 1, **dadurch gekennzeichnet, dass** die Basis-Leiterplatte (16) bei der Montagewandung (5) angeordnet ist.

3. Kommunikationseinheit nach einem der Ansprüche 1 bis 2, **dadurch gekennzeichnet, dass** auf mindestens einer der mehreren Modul-Leiterplatten (17, 18, 19, 20) ein Schnittstellen-Anschluss (15), insbesondere eine Buchse, angeordnet ist, die durch eine der Wandungen des Gehäuses (6, 7) geführt ist und vorzugsweise mit dieser Wandung (6, 7) im Wesentlichen bündig abschließt.

4. Kommunikationseinheit nach einem der Ansprüche 1 bis 3, **dadurch gekennzeichnet, dass** sich die Basis-Leiterplatte (16) und/oder die mindestens eine Modul-Leiterplatte (17, 18, 19, 20) im Wesentlichen bis nahe an die Wandungen erstreckt, die eine durch die jeweilige Leiterplatte (16, 17, 18, 19, 20) aufgespannte Ebene schneiden.

5. Kommunikationseinheit nach einem der Ansprüche 1 bis 4, **gekennzeichnet durch** eine Steckverbindung zum reversiblen Verbinden der mindestens einen Modul-Leiterplatte (17, 18, 19, 20) mit der Basis-Leiterplatte (16) verbunden ist.

6. Kommunikationseinheit nach einem der Ansprüche 1 bis 5, **gekennzeichnet durch** Lötstifte oder einen Lötkamm (21) zum Verbinden der mindestens einen Modul-Leiterplatte (17, 18, 19, 20) mit der Basis-Leiterplatte (16) verlötet ist.

7. Kommunikationseinheit nach einem der Ansprüche 1 bis 6, **dadurch gekennzeichnet, dass** die Basis-Leiterplatte (16) und/oder eine oder mehrere der mindestens einen Modul-Leiterplatte (17, 18, 19, 20) durch eine oder mehrere Führungsschiene/n an der/den Innenwandung/en gehalten ist/sind.

8. Kommunikationseinheit nach einem der Ansprüche 1 bis 7, **dadurch gekennzeichnet, dass** die Basis-Leiterplatte (16) über Abstandhalter, Distanzhülsen oder Distanzbolzen, insbesondere aus Metall oder Kunststoff, an einer der Wandungen des Gehäuses (1) gehalten ist.

9. Kommunikationseinheit nach einem der Ansprüche 1 bis 8, **dadurch gekennzeichnet, dass** das Netzteil-Modul (17) mit einer elektrischen Energiequelle verbunden ist und vorzugsweise die weitere/n Modul-Leiterplatte/n (18, 19, 20) über die Basis-Leiterplatte (16) mit elektrischer Energie versorgt.

10. Kommunikationseinheit nach einem der Ansprüche 1 bis 9, **dadurch gekennzeichnet, dass** bei Vorsehen mehrerer Modul-Leiterplatten (17, 18, 19, 20) die mehreren Modul-Leiterplatten (17, 18, 19, 20) parallel zueinander angeordnet sind.

11. Kommunikationseinheit nach einem der Ansprüche 1 bis 10, **dadurch gekennzeichnet, dass** die Kommunikationseinheit eine Verbindung zwischen mindestens zwei Netzwerken, insbesondere einem lokalen Netzwerk und einem Weitbereichsnetzwerk, herstellt.

12. Kommunikationseinheit nach Anspruch 11, **dadurch gekennzeichnet, dass** die Verbindung zu den Netzwerken über Ethernet, Powerline-Communication und/ oder Funk hergestellt ist.

## Claims

1. Communication unit, in particular smart meter gateway, having a basic printed circuit board (16), at least one modular printed circuit board (17, 18, 19, 20) and a housing (1) for assembly on a carrier rail (2), in particular on a top-hat rail, wherein a wall of the housing - assembly wall (5) - is constructed as a receiving member (4) for the carrier rail,
wherein the basic printed circuit board (16) and the at least one modular printed circuit board (17, 18, 19, 20) are arranged in the housing (1),
wherein the basic printed circuit board (16) is arranged in a wall (5, 6, 7) of the housing (1) and extends substantially in a plane parallel with this wall,
wherein the at least one modular printed circuit board (17, 18, 19, 20) extends in a plane orthogonal to the basic printed circuit board (16) and orthogonal to an extent direction (x) of the receiving member (4) for the carrier rail (2) and is electrically connected to the basic printed circuit board (16), wherein the extent direction (x) of the receiving member (4) is perpendicular to a modular wall (8) of the housing (1) and
wherein each of the plurality of modular printed circuit boards (17, 18, 19, 20) has a predetermined function region and is constructed as a network component module (17), as a safety module (18), as a communication module (19) or as a radio module (20).

2. Communication unit according to claim 1, **characterised in that** the basic printed circuit board (16) is arranged in the assembly wall (5).

3. Communication unit according to either claim 1 or claim 2, **characterised in that** on at least one of the plurality of modular printed circuit boards (17, 18, 19, 20) there is arranged an interface connection (15), in particular a socket, which is guided through one of the walls of the housing (6, 7) and which preferably terminates substantially flush with this wall (6, 7).

4. Communication unit according to any one of claims 1 to 3, **characterised in that** the basic printed circuit board (16) and/or the at least one modular printed circuit board (17, 18, 19, 20) extends substantially as far as a location close to the walls which intersect with a plane defined by the respective printed circuit board (16, 17, 18, 19, 20).

5. Communication unit according to any one of claims 1 to 4, **characterised by** a plug type connection for reversibly connecting the at least one modular printed circuit board (17, 18, 19, 20) to the basic printed circuit board (16).

6. Communication unit according to any one of claims 1 to 5, **characterised by** solder pins or a solder comb (21) for connecting the at least one modular printed circuit board (17, 18, 19, 20) to the basic printed circuit board (16).

7. Communication unit according to any one of claims 1 to 6, **characterised in that** the basic printed circuit board (16) and/or one or more of the at least one modular printed circuit board(s) (17, 18, 19, 20) is/are retained by one or more guide rail(s) on the inner wall(s).

8. Communication unit according to any one of claims 1 to 7, **characterised in that** the basic printed circuit board (16) is retained by means of spacers, spacer sleeves or distance bolts, in particular of metal or plastics material, on one of the walls of the housing (1).

9. Communication unit according to any one of claims 1 to 8, **characterised in that** the network component module (17) is connected to an electrical energy source and preferably supplies the additional modular printed circuit board(s) (18, 19, 20) with electrical energy via the basic printed circuit board (16).

10. Communication unit according to any one of claims 1 to 9, **characterised in that**, when a plurality of modular printed circuit boards (17, 18, 19, 20) are provided, the plurality of modular printed circuit boards (17, 18, 19, 20) are arranged parallel with each other.

11. Communication unit according to any one of claims 1 to 10, **characterised in that** the communication unit produces a connection between at least two networks, in particular a local network and a wide area network.

12. Communication unit according to claim 11, **characterised in that** the connection to the networks is produced by means of Ethernet, Powerline communication and/or radio.

## Revendications

1. Unité de communication, plus particulièrement passerelle SmartMeter, avec un circuit imprimé de base (16), au moins un circuit imprimé modulaire (17, 18, 19, 20) et un boîtier (1) pour le montage sur un rail porteur (2), plus particulièrement sur un rail DIN, une paroi du boîtier, la paroi de montage (5) étant conçue comme un logement (4) pour le rail porteur,
le circuit imprimé de base (16) et l'au moins un circuit imprimé modulaire (17, 18, 19, 20) étant disposés dans le boîtier (1),
le circuit imprimé de base (16) étant disposé près d'une paroi (5, 6, 7) du boîtier (1) et s'étendant globalement dans un plan parallèle à cette paroi,
l'au moins un circuit imprimé modulaire (17, 18, 19, 20) s'étendant dans un plan orthogonal au circuit imprimé de base (16) et orthogonal à une direction d'extension (x) du logement (4) pour le rail porteur (2) et étant relié électriquement avec le circuit imprimé de base (16), la direction d'extension (x) du logement (4) étant perpendiculaire à une paroi de juxtaposition (8) du boîtier (1) et
chacun des circuits imprimés modulaires (17, 18, 19, 20) présentant une plage fonctionnelle prédéterminée et étant conçu comme un module de bloc d'alimentation (17), comme un module de sécurité (18), comme un module de communication (19) ou comme un module radio (20).

2. Unité de communication selon la revendication 1, **caractérisée en ce que** le circuit imprimé de base (16) est disposé près de la paroi de montage (5).

3. Unité de communication selon l'une des revendications 1 à 2, **caractérisée en ce que**, sur au moins un des plusieurs circuits imprimés modulaires (17, 18, 19, 20), est disposé un raccord d'interface (15), plus particulièrement une prise femelle, qui est guidée à travers une des parois du boîtier (6, 7) et de préférence se termine globalement en affleurement avec cette paroi (6, 7).

4. Unité de communication selon l'une des revendications 1 à 3, **caractérisée en ce que** le circuit imprimé de base (16) et/ou l'au moins un circuit imprimé modulaire (17, 18, 19, 20) s'étend globalement jusqu'à proximité des parois, qui coupent un plan qui s'étend à travers le circuit imprimé (17, 18, 19, 20) correspondant.

5. Unité de communication selon l'une des revendications 1 à 4, **caractérisée par** une liaison enfichée pour la liaison réversible de l'au moins un circuit imprimé modulaire (17, 18, 19, 20) avec le circuit imprimé de base (16).

6. Unité de communication selon l'une des revendications 1 à 5, **caractérisée par** des broches à souder ou un peigne à souder (21) pour la soudure de l'au moins un circuit imprimé modulaire (17, 18, 19, 20) avec le circuit imprimé de base (16).

7. Unité de communication selon l'une des revendications 1 à 6, **caractérisée en ce que** le circuit imprimé de base (16) et/ou un ou plusieurs des circuits imprimés modulaires (17, 18, 19, 20) est/sont maintenu(s) par un ou plusieurs rail(s) de guidage sur la/les parois(s) interne(s).

8. Unité de communication selon l'une des revendications 1 à 7, **caractérisée en ce que** le circuit imprimé de base (16) est maintenu, par l'intermédiaire d'entretoises, de manchons d'écartement ou de tiges d'écartement, plus particulièrement en métal ou en matière plastique, contre une des parois du boîtier (1).

9. Unité de communication selon l'une des revendications 1 à 8, **caractérisée en ce que** le module de bloc d'alimentation (17) est relié avec une source d'énergie électrique et alimente de préférence les autres circuits imprimés modulaires (18, 19, 20) en énergie électrique par l'intermédiaire du circuit imprimé de base (16).

10. Unité de communication selon l'une des revendications 1 à 9, **caractérisée en ce que**, dans le cas de plusieurs circuits imprimés modulaires (17, 18, 19, 20), les plusieurs circuits imprimés modulaires (17, 18, 19, 20) sont disposés parallèlement entre eux.

11. Unité de communication selon l'une des revendications 1 à 10, **caractérisée en ce que** l'unité de communication établit une liaison entre au moins deux réseaux, plus particulièrement un réseau local et un réseau étendu.

12. Unité de communication selon la revendication 11, **caractérisée en ce que** la liaison avec les réseaux est établie par Ethernet, Powerline-Communication et/ou radio.
